# EUROPEAN PATENT APPLICATION

(11) **EP 4 398 298 A1**
(43) Date of publication of application: **10.07.2024**
(21) Application number: 23190848.4
(22) Date of filing: 10.08.2023
(51) Int. Cl.: H01L 25/065, H01L 23/48, H01L 23/528, H01L 21/98, H01L 23/485, H01L 25/18

(54) **SEMICONDUCTOR PACKAGE AND METHOD OF MANUFACTURING THE SAME**

(30) Priority: 05.01.2023 KR 20230001952
(71) Applicant: Samsung Electronics Co., Ltd., Suwon-si, Gyeonggi-do 16677 (KR)
(72) Inventor: JEON, Hyungjun, Suwon-si (KR); MOON, Kwangjin, Suwon-si (KR)
(74) Representative: Marks & Clerk LLP

(57) **Abstract**

A semiconductor package includes a first chip and a second chip bonded to and electrically connected to a front surface of the first chip. The first chip includes a first semiconductor substrate including a first through via, a semiconductor element positioned on a front surface of the first semiconductor substrate, and a back side wiring layer including a back side power wiring positioned on a rear surface of the first semiconductor substrate and electrically connected to the semiconductor element unit. The second chip includes a second through via having a size greater than a size of the first through via.

## Description

### TECHNICAL FIELD

Embodiments of the present disclosure relate to a semiconductor package and a method of manufacturing the same, and more particularly, to a semiconductor package having an improved structure, and a method of manufacturing the same.

### DISCUSSION OF RELATED ART

A semiconductor device may have a small size while performing various functions, and is thus widely used in various electronic industries. As advancements are made in the electronic industry, research on micro-fabrication technology and packaging technology has continued to reduce the size of the semiconductor device while also increasing its performance.

A backside power distribution network (BSPDN) structure is used in which a power distribution network (PDN) providing power to the semiconductor device is separated from a signal wiring layer and positioned on the back side of the semiconductor device.

In this regard, the semiconductor device having a backside power distribution network structure is conventionally configured at a monolithic chip level, that is, in the form of a single chip.

### SUMMARY

Embodiments of the present disclosure provide a semiconductor device having a reduced size which also has decreased power consumption and improved performance. For example, an embodiment may provide a semiconductor device having a backside power distribution network structure that has decreased power consumption and improved performance and a reduced size.

According to an embodiment, a semiconductor package includes a first chip including a first semiconductor substrate including a first through via, a semiconductor element positioned on a front surface of the first semiconductor substrate, and a back side wiring layer including a back side power wiring positioned on a rear surface of the first semiconductor substrate and electrically connected to the semiconductor element unit. The semiconductor package further includes a second chip bonded and electrically connected to a front surface of the first chip, and including a second through via having a size greater than a size of the first through via.

The first chip may have a finer wiring structure or finer pattern than the second chip.

The first chip may have a first contact gate or wiring pitch equal to about 10 nm or less, and the second chip may have a second contact gate or wiring pitch greater than the first contact gate or wiring pitch and equal to about of 3 nm to about 50 nm.

The second chip may further include a second semiconductor substrate, and a thickness of the second semiconductor substrate may be greater than a thickness of the first semiconductor substrate.

The thickness of the first semiconductor substrate may be equal to about 150 nm to about 700 nm, and the thickness of the second semiconductor substrate may be equal to about 50 µm or less.

A diameter of the first through via may be equal to about 1 µm or less, and a diameter of the second through via may be equal to about 1 µm or more.

The first chip may be a logic unit, and the second chip may be a memory unit.

The first through via may include a first signal through via that transfers an input/output signal.

The first through via may include a first signal through via that transfers an input/output signal and a first power through via that transfers power. A size of the first signal through via may be greater than a size of the first power through via.

A diameter of the first power through via may be equal to about 100 nm or less, and a diameter of the first signal through via may be equal to about 100 nm to about 1 µm.

The first chip may further include a buried wiring electrically connecting a first transistor of the semiconductor element with the back side power wiring.

The buried wiring may extend from a back side of the first transistor to the back side power wiring.

The first chip and the second chip may be bonded with each other by hybrid bonding.

The second chip may further include a transistor positioned on a surface of the second chip that is bonded to the first chip, and the first chip and the second chip may have a face-to-face structure by being bonded with each other.

The semiconductor package may further include a third chip bonded to a second surface of the second chip that is opposite to a first surface of the second chip bonded to the first chip, a third semiconductor substrate, or a heat dissipation member.

The second chip and the third chip may be bonded with each other by hybrid bonding or bonding using a bump.

According to an embodiment, a semiconductor package includes a first chip including a first semiconductor substrate including a first through via, and a back side wiring layer including a back side power wiring positioned on a rear surface of the first semiconductor substrate. The semiconductor package may further include a second chip bonded to and electrically connected to a front surface of the first chip, and including a second semiconductor substrate including a second through via having a size greater than a size of the first through via and having a thickness greater a thickness of the first semiconductor substrate.

According to an embodiment, a method of manufacturing a semiconductor package includes forming a first chip including a first semiconductor substrate including a first through via, a semiconductor element positioned on a front surface of the first semiconductor substrate, and a back side wiring layer including a back side power wiring positioned on a rear surface of the first semiconductor substrate and electrically connected to the semiconductor element. The method further includes forming a laminated structure in which a second chip including a second through via having a size greater than a size of the first through via is bonded to a front surface of the first chip.

In the forming of the laminated structure, the first chip and a second semiconductor substrate of the second chip may be bonded with each other by hybrid bonding.

The method may further include bonding a third chip onto the laminated structure by hybrid bonding or bonding using a bump.

According to an embodiment, the first chip including an element utilizing a fine wiring structure or fine pattern and the back side wiring layer (e.g., back side power distribution network) and the second chip including an element capable of having a larger wiring structure or pattern may be laminated or stacked to effectively implement a fine process and greatly reduce the size of the semiconductor package.

Here, the power or input/output signal path may be minimized or reduced by the first through via of the first chip and the second through via of the second chip. The first chip may include the smaller first through via and the second chip may include the larger second through via, which may increase the structural stability and increase transfer efficiency of the power or input/output signal. For example, the resistance during the input/output signal transfer may be minimized or reduced by forming the first signal through via larger than the first power through via in the first chip. As a result, power consumption may be decreased and performance of the semiconductor package may be increased.

In addition, the third chip capable of performing various roles may be additionally positioned on the second chip, which may further increase the performance of the semiconductor package. Alternatively, the heat dissipation characteristics may be improved by bonding the heat dissipation member onto the laminated structure in which the first and second chips are laminated or stacked.

In a method of manufacturing a semiconductor package according to an embodiment, the performance of the semiconductor package may be increased by using a manufacturing process in which a bonding method is utilized in consideration of the structures of the first chip, the second chip, and/or the third chip.

At least some of the above and other features of the invention are set out in the claims.

### BRIEF DESCRIPTION OF THE DRAWINGS

The above and other features of the present disclosure will become more apparent by describing in detail embodiments thereof with reference to the accompanying drawings.
FIG. 1 is a perspective view schematically showing a semiconductor package according to an embodiment.
FIG. 2 is a partial cross-sectional view schematically showing the semiconductor package shown in FIG. 1.
FIG. 3 is a view showing an example in which the semiconductor package according to an embodiment is an application processor system.
FIG. 4 is a flowchart showing a method of manufacturing a semiconductor package according to an embodiment.
FIGS. 5A to 5E are process diagrams showing forming a first chip in a method of manufacturing a semiconductor package according to an embodiment.
FIGS. 6A to 6D are process diagrams showing forming a laminated structure in a method of manufacturing a semiconductor package according to an embodiment.
FIG. 7 is a process diagram showing bonding a third chip in a method of manufacturing a semiconductor package according to an embodiment.
FIG. 8 is a partial cross-sectional view schematically showing a semiconductor package according to an embodiment.
FIG. 9 is a partial cross-sectional view schematically showing a semiconductor package according to an embodiment.
FIG. 10 is a partial cross-sectional view schematically showing a semiconductor package according to an embodiment.
FIG. 11 is a partial cross-sectional view schematically showing a semiconductor package according to an embodiment.
FIG. 12 is a partial cross-sectional view schematically showing a semiconductor package according to an embodiment.

### DETAILED DESCRIPTION OF THE EMBODIMENTS

Embodiments of the present disclosure will be described more fully hereinafter with reference to the accompanying drawings. Like reference numerals may refer to like elements throughout the accompanying drawings.

It will be understood that when a component such as a film, a region, a layer, etc., is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. It will also be understood that when a component is referred to as "covering" another component, it can be the only component covering the other component, or one or more intervening components may also be covering the other component. Other words used to describe the relationships between components should be interpreted in a like fashion.

In addition, throughout the present specification, unless especially described to the contrary, "including" any components may be understood to imply the inclusion of other elements rather than the exclusion of any other elements.

Further, throughout the specification, the word "on the plane" may indicate a case where a target is viewed from the top, and the word "on the cross section" may indicate a case where a cross section of a target taken along a vertical direction is viewed from the side.

It will be understood that the terms "first," "second," "third," etc. are used herein to distinguish one element from another, and the elements are not limited by these terms. Thus, a "first" element in an embodiment may be described as a "second" element in another embodiment.

It should be understood that descriptions of features or aspects within each embodiment should typically be considered as available for other similar features or aspects in other embodiments, unless the context clearly indicates otherwise.

As used herein, the singular forms "a", "an" and "the" are intended to include the plural forms as well, unless the context clearly indicates otherwise.

Spatially relative terms, such as "beneath", "below", "lower", "under", "above", "upper", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the terms "below" and "under" can encompass both an orientation of above and below.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art. Further, it is to be understood that while parameters may be described herein as having "about" a certain value, according to embodiments, the parameter may be exactly the certain value or approximately the certain value within a measurement error as would be understood by a person having ordinary skill in the art.

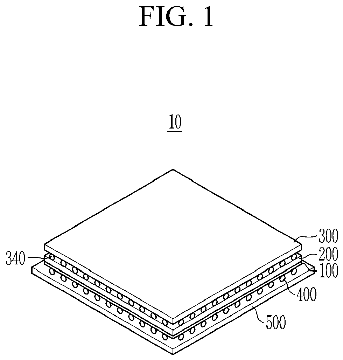

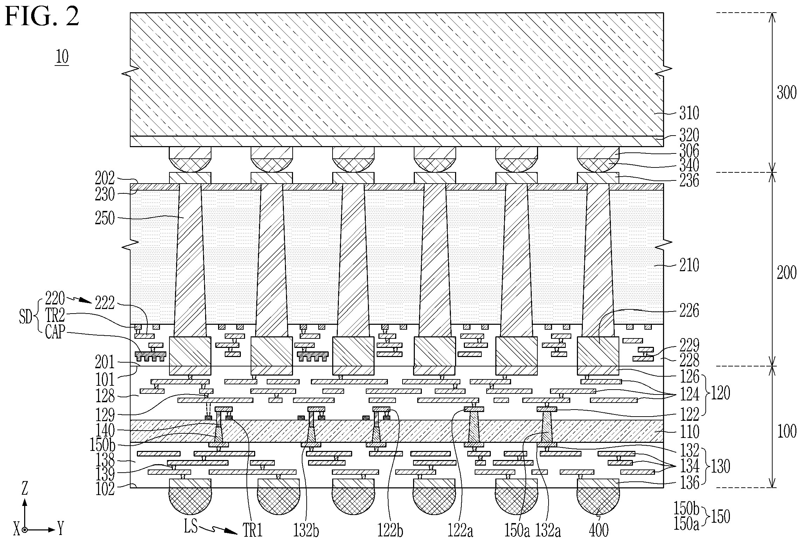

Hereinafter, a semiconductor package according to an embodiment is described in detail with reference to FIGS. 1 and 2.

FIG. 1 is a perspective view schematically showing a semiconductor package 10 according to an embodiment. FIG. 2 is a partial cross-sectional view schematically showing the semiconductor package 10 shown in FIG. 1. FIG. 1 is a simple view mainly showing a first chip 100, a second chip 200, a third chip 300, and a package substrate 500, and FIG. 2 omits the package substrate 500.

Referring to FIGS. 1 and 2, the semiconductor package 10 according to an embodiment may include a first chip 100 including a first through via 150, a first semiconductor element unit LS, and a back side wiring layer 130. The first through 150 via may include a first signal through via 150a and a first power through via 150b. The semiconductor package 10 may further include a second chip 200 laminated or stacked on and bonded to the first chip 100 and including a second through via 250 having a size greater than that of the first through via 150. In addition, the semiconductor package 10 may further include the third chip 300 laminated or stacked on and bonded to the second chip 200.

In this specification, the first chip 100, the second chip 200, and the third chip 300 may each be a semiconductor chip or semiconductor chiplet including a semiconductor element or a semiconductor substrate.

In an embodiment, the first chip 100 may include a first semiconductor substrate 110 including the first through via 150, the first semiconductor element unit LS positioned on the front surface of the first semiconductor substrate 110, and the back side wiring layer 130 including a back side power wiring positioned on the rear surface of the first semiconductor substrate 110 and electrically connected to the first semiconductor element unit LS. In addition, the first chip 100 may further include a buried wiring 140 electrically connecting a first transistor TR1 of the first semiconductor element unit LS with the back side power wiring of the back side wiring layer 130 together with the first through via 150, and a front side wiring layer 120 formed on the front surfaces of the first semiconductor substrate 110 and the first semiconductor element unit LS.

The first semiconductor substrate 110 may be, for example, a silicon substrate, a germanium substrate, a silicon-germanium substrate, a silicon-on-insulator (SOI) substrate, or a germanium-on-insulator (GOI) substrate. For example, the first semiconductor substrate 110 may be the silicon substrate.

In this case, the first semiconductor element unit LS positioned on the front surface of the first semiconductor substrate 110 may include the first transistor TR1 and include any of various semiconductor elements. In an embodiment, the first semiconductor element unit LS may be a logic structure including any of various logic elements. Thus, the first semiconductor element unit LS may also be referred to herein as a first semiconductor element, a first semiconductor logic element, a first semiconductor circuit element, etc. For example, the plurality of first transistors TR1 may be provided, and the plurality of first transistors TR1 may be used alone or in combination with other elements to form any of various logic elements such as, for an example, an AND logic element, an OR logic element, a NOR logic element, and an inverter. However, embodiments are not limited thereto. For example, in an embodiment, the first semiconductor element unit LS may be a semiconductor element unit other than a logic structure. In this specification, the first semiconductor element unit LS being positioned on the front surface of the first semiconductor substrate 110 may not only indicate that the first semiconductor element unit LS is formed on the front surface of the first semiconductor substrate 110, but also indicate that the first semiconductor element unit LS is formed on the front surface of the first semiconductor substrate 110 while including a portion of the first semiconductor substrate 110.

In an embodiment, the first transistor TR1 may have any of various structures. For example, the first transistor TR1 may be a three-dimensional field effect transistor (FET) having a fin structure, a gate-all-around (GAA) structure, a multi-bridge-channel (MBC) structure, or the like. The first transistor TR1 may reduce a leakage current and provide increased performance when having the three-dimensional structure as described above.

The back side wiring layer 130 formed on the rear surface of the first semiconductor substrate 110 may include a plurality of wiring layers 132 and 134 forming the back side power wiring and a first rear surface pad 136. In an embodiment, the back side power wiring or back side wiring layer 130 may be a back side power delivery network or back side power distribution network (BSPDN).

In an embodiment, the back side power wiring or back side wiring layer 130 may be electrically connected to the first semiconductor element unit LS, for example, the first transistor TR1, by the first through via 150 and/or the buried wiring 140. Accordingly, the back side wiring layer 130 including the back side power wiring may transfer power to the first transistor TR1. For example, a power voltage or a ground voltage may be transferred to the first transistor TR1 through the back side wiring layer 130.

The plurality of wiring layers 132 and 134 may be laminated while having an interlayer insulating layer 138 interposed therebetween and connected with each other in a predetermined path through a contact plug 139. For example, the plurality of wiring layers 132 and 134 may include a first back side layer 132 adjacent to the rear surface of the first semiconductor substrate 110 and one or more second back side layers 134 positioned on the rear surface of the first back side layer 132.

In this case, the first back side layer 132 may include pad parts 132a and 132b connected to the first through via 150. For example, in an embodiment, the pad parts 132a and 132b may include the first pad part 132a connected to the first signal through via 150a and the second pad part 132b connected to the first power through via 150b. The first signal through via 150a and the first power through via 150b are described in detail below.

The plurality of wiring layers 132 and 134 may be the back side power wiring that transfers power. The back side wiring layer 130 may have a separate wiring or structure that transfers input/output signals to the first signal through via 150a, and the input/output signals may be provided to the first signal through via 150a through a portion of the back side power wiring.

The first rear surface pad 136 may be an outermost wiring layer of the back side wiring layer 130. The first rear surface pad 136 may correspond to a bonding pad positioned on a rear surface 102 of the first chip 100 and connected to a connection bump 400 among a plurality of connection bumps 400, an external circuit, or the like. In this case, the first rear surface pad 136 may include a power pad that transfers power to the first transistor TR1 and a signal pad that transfers the input/output signals to the first signal through via 150a.

FIG. 1 illustrates that a laminate including the first chip 100, the second chip 200, and the third chip 300 is fixed to the package substrate 500 by the connection bumps 400. The package substrate 500 may include a printed circuit board including a connection pad connected to the connection bump 400. The connection bump 400 may include at least one of, for example, copper, aluminum, tungsten, nickel, tin, titanium, tantalum, indium, molybdenum, manganese, cobalt, magnesium, rhenium, beryllium, gallium, and ruthenium, or an alloy including the same. However, embodiments are not limited thereto.

Parts of the back side wiring layer 130 that function as the wiring, that is, the plurality of wiring layers 132 and 134, the contact plug 139, and the first rear surface pad 136, may include any of various conductive materials. At least two of the plurality of wiring layers 132 and 134, the contact plug 139, and the first rear surface pad 136 may be made of the same material or may include different materials. In addition, each of the plurality of wiring layers 132 and 134, the contact plug 139, and/or the first rear surface pad 136 may be a single layer or a plurality of layers. For example, each of the plurality of wiring layers 132 and 134, the contact plug 139, and/or the first rear surface pad 136 may include at least one of copper, aluminum, tungsten, nickel, gold, tin, and titanium, or an alloy including the same. The interlayer insulating layer 138 may include any of various insulating materials that may insulate the plurality of wiring layers 132 and 134 and/or the first rear surface pad 136 from one another.

In an embodiment, the buried wiring 140 may be provided to electrically connect the first transistor TR1 positioned on the front surface of the first semiconductor substrate 110 with the back side wiring layer 130 positioned on the rear surface of the first semiconductor substrate 110. For example, the buried wiring 140 may be a buried power rail (BPR).

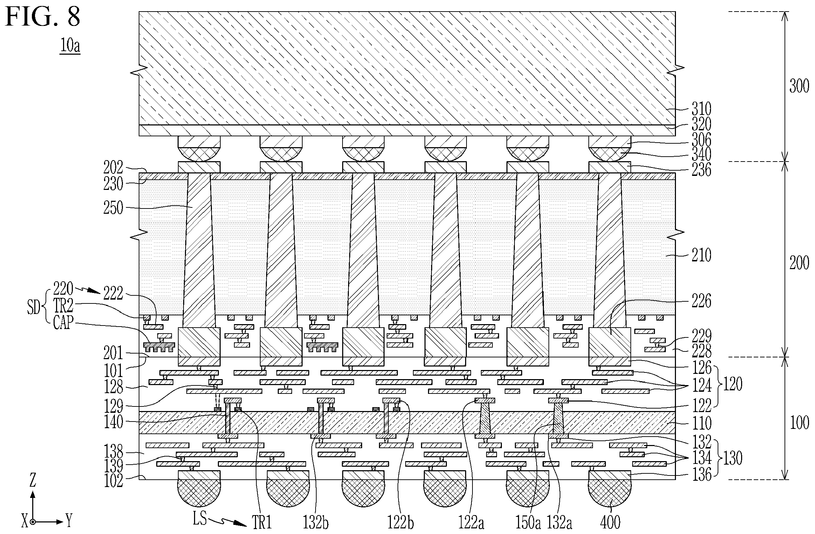

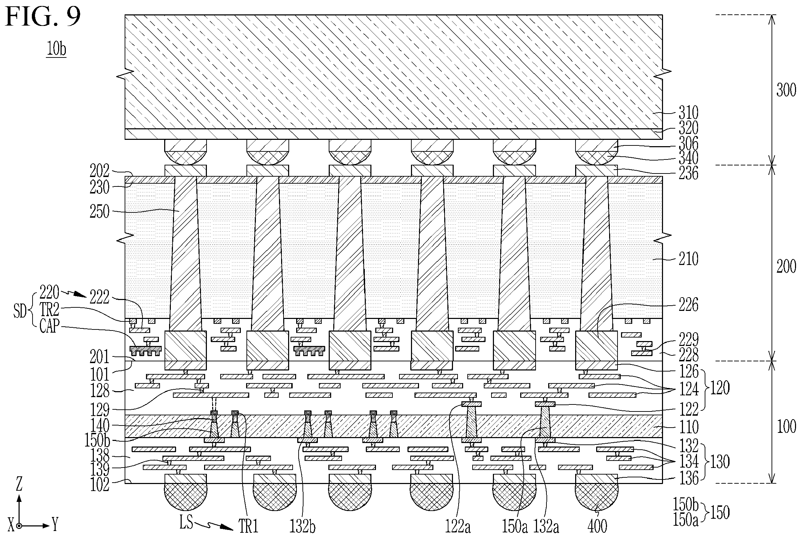

The buried wiring 140 may be formed over a portion or all of the first semiconductor substrate 110 in a thickness direction (e.g., the Z direction in FIG. 2) of the first semiconductor substrate 110. For example, the buried wiring 140 may be formed on a portion of the front surface of the first semiconductor substrate 110 in an element separation unit positioned between the two adjacent first transistors TR1, and the first power through via 150b may connect the back side of the buried wiring 140 and the second pad part 132b. Accordingly, a wiring structure may be simplified by the first power through via 150b. In addition, an embodiment illustrates that the buried wiring 140 is electrically connected to the first transistor TR1 through the front side wiring layer 120 (e.g., a connection part 122b of a first front side layer 122). However, embodiments are not limited thereto. For example, according to embodiments, a structure for connecting the buried wiring 140 with the first transistor TR1 may be modified in various ways. Embodiments are described in more detail below with reference to FIGS. 8 and 9.

In an embodiment, the first through via 150 passing through all or a portion of the first semiconductor substrate 110 may be provided in the first semiconductor substrate 110. For example, the first through via 150 may include the first signal through via 150a that transfers the input/output signals and the first power through via 150b that transfers power. For example, the first signal through via 150a may be electrically connected to the signal pad among the first rear surface pads 136, a front side signal wiring included in the front side wiring layer 120, or the like. In addition, the power through via 150b may be electrically connected to the power pad, the back side power wiring included in the first back side layer 132, the buried wiring 140, or the like.

In an embodiment, the first through via 150 may be a through silicon via (TSV). In an embodiment, the first through via 150 may be a nano through silicon via (nTSV) having a nanometer level size. That is, in an embodiment, the first through via 150 may have a diameter of about 1 µm or less. For example, a size of the first signal through via 150a may be greater than that of the first power through via 150b, and the number of the first signal through vias 150a may be smaller than the number of the first power through vias 150b. In an embodiment, the first power through via 150b may be designed to have a greater number while having a smaller size, and the first signal through via 150a may have a greater size in consideration of resistance and the like. However, embodiments are not limited thereto. For example, according to embodiments, a size relationship between the first signal through via 150a and the first power through via 150b such as the number and the size may depend on the design. The sizes of the first through via 150, the first signal through via 150a, and the first power through via 150b are described in more detail below.

According to embodiments, the first signal through via 150a may entirely pass through the first semiconductor substrate 110 and extend from the rear surface of the first semiconductor substrate 110 to the front surface of the first semiconductor substrate 110. For example, the first signal through via 150a may extend to connect the first back side layer 132 (e.g., the first pad part 132a) with the first front layer 122 (e.g., a pad part 122a). However, embodiments are not limited thereto. For example, according to embodiments, the first signal through via 150a may be connected to a wiring layer other than the first back side layer 132 and/or the first front side layer 122.

For example, the first power through via 150b may extend from the rear surface of the first semiconductor substrate 110 to the back side of the buried wiring 140. For example, the first power through via 150b may extend to connect the first back side layer 132 (e.g., the second pad part 132b) with the back side of the buried wiring 140. However, embodiments are not limited thereto. For example, according to embodiments, the first power through via 150b may be connected to a wiring layer other than the first back side layer 132 of the back side wiring layer 130.

An embodiment illustrates that the first through via 150 includes the first signal through via 150a and the first power through via 150b. However, embodiments are not limited thereto. For example, in an embodiment, the first through via 150 does not include at least one of the first signal through via 150a and the first power through via 150b. For example, the first through via 150 may include the first signal through via 150a without the first power through via 150b. This configuration is described in more detail with reference to FIG. 8 below. Alternatively, the first through via 150 may include the first power through via 150b without the first signal through via 150a.

The first through via 150 may include any of various conductive materials, such as, for example, metal. For example, the first through via 150 may include at least one of copper, aluminum, tungsten, nickel, titanium, tantalum, ruthenium, cobalt, and manganese, or an alloy including the same. The first through via 150 may be a single layer or a plurality of layers. According to embodiments, an insulating layer may be positioned between a sidewall of the first through via 150 and the first semiconductor substrate 110.

The front side wiring layer 120 formed on the front surface of the first semiconductor substrate 110 may include a plurality of wiring layers 122 and 124 included in the front side signal wiring and a first front surface pad 126. Some of the wiring layers 122 may also be referred to as first front side layers 122 or first front layers 122, and some of the wiring layers 124 may also be referred to as second front side layers 122 or second front layers 122.

In an embodiment, the front side signal wiring or front side wiring layer 120 may be electrically connected to the first signal through via 150a. For example, the front side wiring layer 120 including the front side signal wiring may transfer the input/output signals transferred through the first signal through via 150a to a gate of the first transistor TR1.

The plurality of wiring layers 122 and 124 may be laminated while having an interlayer insulating layer 128 interposed therebetween and connected with each other in a predetermined path through a contact plug 129. For example, the plurality of wiring layers 122 and 124 may include the first front side layer 122 adjacent to the front surface of the first semiconductor substrate 110, and one or more second front side layers 124 positioned on the front surface of the first front side layer 122 and providing a signal transfer path.

Here, the first front side layer 122 may include the pad part 122a electrically connected to the first signal through via 150a, and the connection part 122b electrically connecting the first transistor TR1 with the buried wiring 140. For reference, the connection part 122b of the first front side layer 122 may be referred to as a tap cell.

As described above, the plurality of wiring layers 122 and 124 may form the front side signal wiring that transfers the signal. The front side wiring layer 120 may include a separate wiring or structure that transfers power and/or signals provided to the second chip 200 and/or the third chip 300 to the first front surface pad 126. Alternatively, the power and/or signals provided to the second chip 200 and/or the third chip 300 may be transferred to the first front surface pad 126 through a portion of the front side signal wiring.

The first front surface pad 126 may be an outermost wiring layer of the front side wiring layer 120. The first front surface pad 126 may correspond to a bonding pad connected or bonded to a first pad 226 of the second chip 200.

Parts of the front side wiring layer 120 that function as the wiring, that is, the plurality of wiring layers 122 and 124, the contact plug 129, and the first front surface pad 126, may include any of various conductive materials. At least two of the plurality of wiring layers 122 and 124, the contact plug 129, and the first front surface pad 126 may be made of the same material or may include different materials. In addition, each of the plurality of wiring layers 122 and 124, the contact plug 129, and/or the first front surface pad 126 may be a single layer or a plurality of layers. For example, each of the plurality of wiring layers 122 and 124, the contact plug 129, and/or the first front surface pad 126 may include at least one of copper, aluminum, tungsten, nickel, gold, tin, and titanium, or an alloy including the same. For example, the first front surface pad 126 may include copper. The interlayer insulating layer 128 may include any of various insulating materials that may insulate the plurality of wiring layers 122 and 124 and/or the first front surface pad 126 from one another.

For convenience of illustration, FIG. 2 only schematically shows the structures of the first semiconductor element unit (LS), the front side wiring layer 120, and the back side wiring layer 130. However, embodiments are not limited thereto. In addition, for convenience of illustration, FIG. 2 shows that the first power through via 150b is positioned on the left side and the first signal through via 150a is positioned on the right side. However, in practice, the arrangements of the first power through via 150b and the first signal through via 150a are not limited thereto, and may be variously modified. As such, FIG. 2 is only a schematic illustration of an embodiment for clear understanding, and embodiments are not limited thereto. Therefore, the arrangement, number, or the like of the members related to the power transfer and the members related to the input/output signal transfer may be variously modified based on the type, design, or the like of the semiconductor package 10.

The second chip 200 electrically connected to the first chip 100 may be bonded to a front surface 101 of the first chip 100 described above.

In an embodiment, the second chip 200 may include a second semiconductor substrate 210 including the second through via 250 having a size larger than that of the first through via 150, and a second semiconductor element unit SD positioned on a first surface (e.g., lower surface in FIG. 2) of the second semiconductor substrate 210 and including a second transistor TR2. In addition, the first pad 226 may be positioned on the first surface 201 (e.g., lower surface in FIG. 2) of the second chip 200, and a second pad 236 may be positioned on a second surface 202 (e.g., upper surface in FIG. 2) of the second chip 200.

The second semiconductor substrate 210 may be, for example, a silicon substrate, a germanium substrate, a silicon-germanium substrate, a silicon-on-insulator substrate, or a germanium-on-insulator substrate. For example, the second semiconductor substrate 210 may be the silicon substrate.

Here, the second semiconductor element unit SD positioned on the first surface side of the second semiconductor substrate 210 may include the second transistor TR2 and a wiring unit 220. In addition, the second semiconductor element unit SD may further include a capacitor CAP, a resistor (R)-inductor (L)-capacitor (C) circuit (e.g., RLC circuit, or the like. As such, the second semiconductor element unit SD may include any of various elements, circuits, and the like to be suitable for a role or function of the second chip 200.

In an embodiment, the second transistor TR2 may have any of various structures. For example, the second transistor TR2 may be a three-dimensional field effect transistor having a fin structure, a gate-all-around structure, or a multi-bridge-channel structure. However, embodiments are not limited thereto. For example, various modifications, such as the second transistor TR2 having a planar structure, may be made according to embodiments.

The wiring unit 220 may include a plurality of wiring layers 222 laminated while having an insulating layer 228 interposed therebetween and connected with each other in a predetermined path through the contact plug 229. The first pad 226 positioned on the first surface 201 of the second chip 200 may be positioned within the insulating layer 228, and at least one surface thereof may be exposed to the first surface 201 of the second chip 200. For example, the second pad 236 positioned on the second surface 202 of the second chip 200 may protrude from the second surface 202 of the second chip 200. An insulating layer 230 may be formed on the second surface of the second semiconductor substrate 210. However, embodiments are not limited thereto, and various modifications are possible.

The wiring layer 222, the contact plug 229, the first pad 226 and/or the second pad 236 may include any of various conductive materials. At least two of the wiring layer 222, the contact plug 229, the first pad 226, and the second pad 236 may be made of the same material or may include different materials. In addition, each of the wiring layer 222, the first pad 226, and/or the second pad 236 may be a single layer or a plurality of layers. For example, the wiring unit 220, the contact plug 229, the first pad 226, and/or the second pad 236 may include at least one of copper, aluminum, tungsten, nickel, gold, tin, and titanium, or an alloy including the same. For example, the first pad 226 or the second pad 236 may include copper. The insulating layer 228 and/or the insulating layer 230 may include any of various insulating materials.

In an embodiment, the second through via 250 passing through all or a portion of the second semiconductor substrate 210 may be provided in the second semiconductor substrate 210. The second through via 250 may include at least one of a signal through via that transfers signals and a power through via that transfers power. For example, the second through via 250 may include the signal through via that transfers signals and the power through via that transfers power. However, embodiments are not limited thereto, and various modifications are possible.

In an embodiment, the second through via 250 may be a through silicon via. In an embodiment, the second through via 250 may be a micro through silicon via (uTSV) having a micrometer level size. That is, in an embodiment, the second through via 250 may have a diameter of about 1 µm or more that is larger than that of the first through via 150. The size of the second through via 250 is described in more detail below.

For example, the second through via 250 may entirely pass through the second semiconductor substrate 210 to extend from the second surface of the second semiconductor substrate 210 to the first surface of the second semiconductor substrate 210. For example, the second through via 250 may extend to connect the first pad 226 with the second pad 236 while passing through the second semiconductor substrate 210.

The second through via 250 may include any of various conductive materials, for example, metal. For example, the second through via 250 may include at least one of copper, aluminum, tungsten, nickel, titanium, tantalum, ruthenium, cobalt, and manganese, or an alloy including the same. The second through via 250 may be a single layer or a plurality of layers. According to embodiments, an insulating layer may be positioned between a sidewall of the second through via 250 and the second semiconductor substrate 210.

In an embodiment, the first chip 100 and the second chip 200 may be bonded with each other by hybrid bonding while the first surface 201 of the second chip 200 where the second transistor TR2 is positioned faces the front surface 101 of the first chip 100 where the first transistor TR1 is positioned. That is, the laminated structure including the first chip 100 and the second chip 200 or the semiconductor package 10 may have a chip-to-chip structure. For example, the first front surface pad 126 positioned in the first chip 100 and the first pad 226 positioned in the second chip 200 may each be a copper bonding pad including copper, and bonded with each other to have a copper-to-copper structure.

Here, the surface (e.g., front surface 101) of the first chip 100 where the first transistor TR1 is positioned and the surface (e.g., first surface 201) of the second chip 200 where the second transistor TR2 is positioned may be bonded with each other. That is, the first chip 100 and the second chip 200 may be bonded with each other to have a face-to-face (F2F) structure. For reference, in an embodiment, the first surface 201 of the second chip 200 where the second semiconductor element unit SD is positioned may be the rear surface positioned on the back side of the semiconductor package 10. However, the first surface 201 may be the front surface of the second semiconductor substrate 210 during a manufacturing process. In addition, the second surface 202 of the second chip 200 may be the front surface positioned on the front side of the semiconductor package 10. However, the second surface 202 may be the rear surface of the second semiconductor substrate 210 during the manufacturing process. In the above-described face-to-face structure, the reference of the front surface and the rear surface may be made based on the front surface and the rear surface during the manufacturing process or the surfaces where the first and second transistors TR1 and TR2 are positioned.

In this way, when the first chip 100 and the second chip 200 are bonded with each other to have the face-to-face structure, surfaces of the first and second chips 100 and 200 where the first and second transistors TR1 and TR2 are not positioned may correspond to outer surfaces other than the bonding surface. Accordingly, heat generated in the first semiconductor element unit LS including the first transistor TR1 and/or the second semiconductor element unit SD including the second transistor TR2 may be easily dissipated to outside of the semiconductor package 10 through the first semiconductor substrate 110 and/or the second semiconductor substrate.

In an embodiment, the first chip 100 may have a finer wiring structure or finer pattern than the second chip 200. Here, to have a fine wiring structure or fine pattern may indicate that a length of a contact gate or wiring pitch, such as a contact gate pitch or a wiring pitch, is smaller. Alternatively, to have a fine wiring structure or fine pattern may indicate that a node in the manufacturing process has a smaller value. For example, the first chip 100 may be formed by a front node, and the second chip 200 may be formed by a legacy node. For example, the first chip 100 may be manufactured by the front node having a first contact gate or wiring pitch of about 10 nm or less (e.g., about 3 nm or less or about 2 nm or less), and the second chip 200 may be manufactured by the legacy node having a second contact gate or wiring pitch of about 3 nm to about 50 nm that is greater than the first contact gate or wiring pitch. However, embodiments are not limited to the above-mentioned numerical values.

In an embodiment, the first chip 100 may be a chip or chiplet having an element having a smaller first contact gate or wiring pitch, and the second chip 200 may be a chip or chiplet having an element having a larger second contact gate or wiring pitch. Accordingly, a manufacturing process of the second chip 200 may be simplified by separately forming the element having a larger second contact gate or wiring pitch on the second chip 200. In addition, a manufacturing process of the first chip 100 may be precisely performed by forming only the element having a smaller first contact gate or wiring pitch on the first chip 100. A size (e.g., area) of the semiconductor package 10 may be reduced by bonding the first chip 100 and the second chip 200 that are manufactured in this way with each other while the chips are vertically laminated.

As described above, the first chip 100 may have a finer wiring structure or finer pattern than the second chip 200. Accordingly, a size of the first through via 150 may be smaller than that of the second through via 250 and the size of the second through via 250 may be larger than that of the first through via 150. In addition, as described above, the size of the first signal through via 150a may be larger than the size of the first power through via 150b.

For example, in an embodiment, the diameter of the first through via 150 may be about 1 µm or less, and the diameter of the second through via 250 may be greater than the diameter of the first through via 150 and may be about 1 µm or more (e.g., about 1 µm to about 10 µm). When the diameter of the first through via 150 is more than about 1 µm, the first through via 150 may not be suitable for the fine wiring structure or fine pattern of the first chip 100. The diameter of the second through via 250 is to sufficiently secure a thickness of the second semiconductor substrate 210 in consideration of the second contact gate or wiring pitch of the second chip 200. When the diameter of the second through via 250 is more than about 10 µm, the second through via 250 may have lower structural stability and there may be a limit to high integration of the semiconductor package 10.

In addition, the diameter of the first power through via 150b may be about 100 nm or less (e.g., about 10 nm to about 100 nm), and the diameter of the first signal through via 150a may be larger than the diameter of the first power through via 150b and may be about 100 nm to about 1 µm. When the diameter of the first power through via 150b is about 100 nm or less (e.g., about 10 nm to about 100 nm), the first power through via 150b may have a small size while transferring power without difficulty. When the diameter of the first signal through via 150a is less than about 100 nm, high resistance may occur during the input/output signal transfer through the first signal through via 150a. When the diameter of the first signal through via 150a is greater than about 1 µm, the first through via 150 may not be suitable for the fine wiring structure or fine pattern of the first chip 100.

However, embodiments of the present disclosure are not limited thereto, as the diameter values of the first signal through via 150a, the first power through via 150b, and/or the second through via 250 may have values different from those described above.

According to embodiments, an aspect ratio of the first through via 150 and the second through via 250 do not exceed a predetermined range, and a thickness of the second semiconductor substrate 210 having the second through via 250 may thus be greater than that of the first semiconductor substrate 110 having the first through via 150. As described above, according to an embodiment, the second semiconductor substrate 210 may be formed thick to increase heat dissipation characteristics through the second semiconductor substrate 210.

For example, the thickness of the first semiconductor substrate 110 may be about 150 nm to about 700 nm (e.g., about 150 nm to about 450 nm), and the thickness of the second semiconductor substrate 210 or a depth of the second through via 250 may be about 50 µm or less (e.g., about 10µm to about 50µm). According to embodiments, the above-mentioned thickness of the first semiconductor substrate 110 is limited to an appropriate range in consideration of the fine wiring structure or fine pattern of the first chip 100, the size of the first through via 150, and the like. In addition, according to embodiments, the above-mentioned thickness of the second semiconductor substrate 210 or the depth of the second through via 250 is limited to a range in which power, the input/output signals, or the like may move smoothly while sufficiently implementing the heat dissipation characteristics through the second semiconductor substrate 210. However, embodiments are not limited thereto. For example, according to embodiments, the thickness of the first semiconductor substrate 110, the thickness of the second semiconductor substrate 210, and/or the depth of the substrate of the second through via 250 may have values different from those described above.

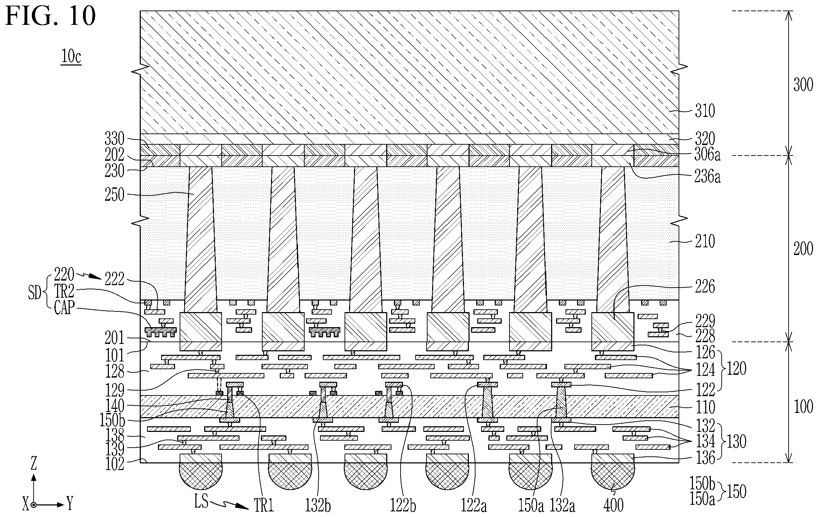

The semiconductor package 10 according to an embodiment may further include the third chip 300 laminated on the second surface 202 of the second chip 200. In an embodiment, the third chip 300 may include a semiconductor element layer 320, a bonding pad 306, and a bump 340 disposed on the surface of the bonding pad 306 facing the second chip 200. Accordingly, the second chip 200 and the third chip 300 may be bonded with each other by bonding the second pad 236 of the second chip 200 with the bonding pad 306 of the third chip 300 by using the bump 340. Here, the bump 340 may be a microbump. However, embodiments are not limited thereto, as described below, for example, with reference to FIG. 10.

In an embodiment, the surface of the second chip 200 where the second transistor TR2 is not positioned and the surface of the third chip 300 where the semiconductor element layer 320 is positioned may be bonded with each other to have a back-to-face (B2F) structure. However, embodiments are not limited thereto, and various modifications are possible.

For example, the semiconductor element layer 320 may include any of various elements, circuits and the like suitable for the role or function of the third chip 300. The bonding pad 306 may include, for example, at least one of copper, aluminum, tungsten, nickel, gold, tin, and titanium, or an alloy including the same. The bump 340 may include at least one of, for example, copper, aluminum, tungsten, nickel, tin, titanium, tantalum, indium, molybdenum, manganese, cobalt, magnesium, rhenium, beryllium, gallium, and ruthenium, or an alloy including the same. However, embodiments are not limited thereto.

FIG. 2 shows that the semiconductor element layer 320 and the bonding pad 306 are positioned on the surface of the third chip 300 that faces the second chip 200. In an embodiment, another bonding pad may be positioned on the opposite surface of the third chip 300 that faces the second chip 200.

The semiconductor package 10 according to an embodiment may include a memory system that stores data, a non-memory system that calculates, processes, or controls information, a complex system in which the memory system and the non-memory system are combined with each other, or the like. According to an embodiment, a desired system may be easily implemented by combining the first chip 100, the second chip 200 and/or the third chip 300 with each other.

For example, a volatile memory system and a non-volatile memory system may be provided as the memory system. The volatile memory system may be, for example, a dynamic random access memory (DRAM) system, a static random access memory (SRAM) system, or the like. The non-volatile memory system may be, for example, a NAND flash memory system or the like.

The non-memory system or the composite system may be, for example, a central processing unit (CPU) system, a graphic processing unit (GPU) system, a neural processing unit (NPU) system, a micro controller unit (MCU) system, an application processor system, an image sensor system, or the like.

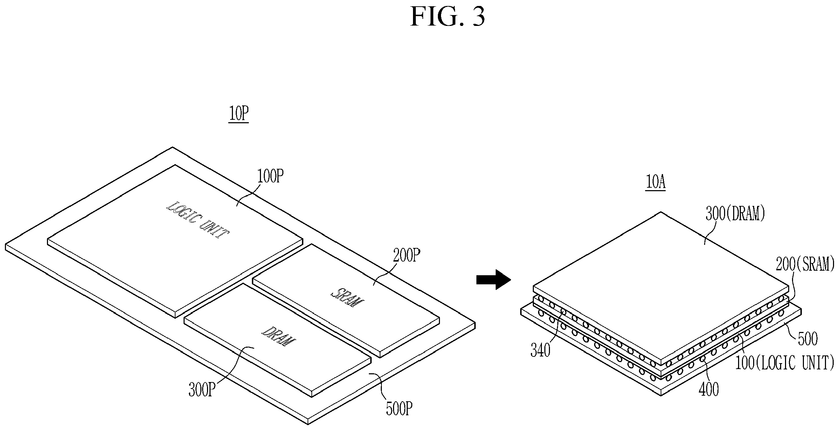

An example of the semiconductor package 10 is described in more detail with reference to FIG. 3.

FIG. 3 is a view showing an example in which the semiconductor package 10 is an application processor system 10A. FIG. 3 shows a schematic perspective view of an application processor system 10P according to a comparative example on the left side, and a schematic perspective view of the application processor system 10A according to an embodiment on the right side.

As shown on the left side of FIG. 3, the application processor system 10P according to a comparative example may include a logic unit 100P including a central processing unit (CPU) and/or a graphic processing unit (GPU), an SRAM 200P functioning as a cache memory, and a DRAM 300P functioning as an auxiliary memory or additional memory that are positioned on one surface of a package substrate 500P while being spaced apart from one another on a plane. FIG. 3 shows one logic unit 100P used for the application processor for simple illustration. However, according to embodiments, a logic unit for a central processing unit and a logic unit for a graphic processing unit may be provided separately from each other. As such, the application processor system 10P according to a comparative example has an area larger than at least the sum of areas of the logic unit 100P, the SRAM 200P, and the DRAM 300P.

On the other hand, as shown on the right side of FIG. 3, the first chip 100 of the application processor system 10A according to an embodiment may include the logic unit including a central processing unit (CPU) and/or a graphics processing unit (GPU). In addition, the second chip 200 may include the SRAM functioning as a cache memory, and the third chip 300 may include the DRAM functioning as an auxiliary memory or additional memory. The second chip 200 and the third chip 300 may be sequentially laminated on the first chip 100, then be bonded with one another, and laminated on and bonded to the package substrate 500 by using the connection bump 400 to form the application processor system 10A. The application processor system 10A may then have an area equivalent to that of the first chip 100, the second chip 200, or the third chip 300, thus, making it possible to effectively reduce the area of the application processor system 10A according to embodiments.

According to embodiments, the first chip 100, the second chip 200, and the third chip 300 may be any of various chips or chiplets that perform various roles to configure various semiconductor packages 10.

For example, the first chip 100 may include a fine wiring structure or fine pattern, and thus, include a logic unit including the first semiconductor element unit LS. The first chip 100 may be, for example, the logic unit for a central processing unit, the logic unit for a graphic processing unit, a logic unit for an application processor, a logic unit for an image sensor, a logic unit for a memory, and the like. In this way, the performance of the semiconductor package 10 may be increased by forming the logic unit to have the fine wiring structure or fine pattern. The second chip 200 and/or the third chip 300 may be a memory unit including, for example, the SRAM, the DRAM, and the NAND flash memory, as the memory unit may have a larger wiring structure or pattern than that of the logic unit. However, embodiments are not limited thereto, and the first chip 100, the second chip 200, and the third chip 300 may be variously modified.

As described above, in the semiconductor package 10 according to an embodiment, the first chip 100 including an element utilizing a fine wiring structure or fine pattern and the back side wiring layer 130 (e.g., back side power distribution network) and the second chip 200 including an element capable of having a larger wiring structure or pattern may be laminated to effectively implement a fine process and effectively reduce the size of the semiconductor package 10.

Here, a power or input/output signal path may be minimized or reduced by the first through via 150 of the first chip 100 and the second through via 250 of the second chip 200. The first chip 100 may include the smaller first through via 150 and the second chip 200 may include the larger second through via 250 to increase the structural stability and increase transfer efficiency of power or input/output signal. For example, the resistance during the input/output signal transfer may be minimized or reduced by forming the first signal through via 150a larger than the first power through via 150b in the first chip 100, thus decreasing the power consumption and increasing performance of the semiconductor package 10 according to embodiments.

In addition, the third chip 300 capable of performing various roles may be additionally positioned on the second chip 200 to further increase the performance of the semiconductor package 10 according to embodiments.

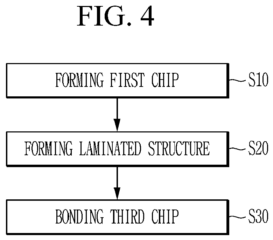

A method of manufacturing the above-described semiconductor package is described in detail with reference to FIGS. 4, 5A to 5E, 6A to 6D, and 7 together with FIGS. 1 and 2. For convenience of explanation, a further description of components and technical aspects may be omitted.

FIG. 4 is a flowchart showing a method of manufacturing a semiconductor package 10 according to an embodiment. Referring to FIG. 4, the method of manufacturing a semiconductor package 10 according to an embodiment may include forming a first chip (S10), forming a laminated structure (S20), and bonding a third chip (S30).

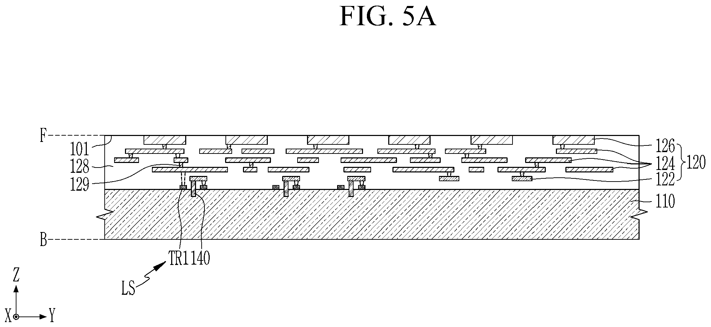

The forming of the first chip (S10) is described in detail with reference to FIGS. 5A to 5E. FIGS. 5A to 5E are process diagrams showing the forming of the first chip (S10) in the method of manufacturing a semiconductor package 10 according to an embodiment. For clear understanding, in FIGS. 5A to 5E, the front surface of the first semiconductor substrate 110 is indicated by F and the rear surface of the first semiconductor substrate 110 is indicated by B.

As shown in FIG. 5A, a first semiconductor element unit LS including a first transistor TR1, a buried wiring 140, and a front side wiring layer 120 may be formed on the front surface of a first semiconductor substrate 110. Here, a front side wiring layer 120 having a desired path may be formed by insulating or connecting a plurality of wiring layers 122 and 124 and a first front surface pad 126 from each other or with each other by using an interlayer insulating layer 128 and a contact plug 129. The first semiconductor element unit LS, the buried wiring 140, and the front side wiring layer 120 may be formed by any of various manufacturing processes, and embodiments are not limited thereto.

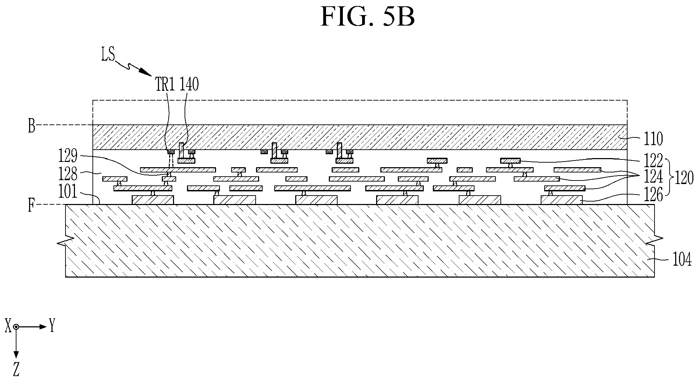

Next, as shown in FIG. 5B, the front surface of the first semiconductor substrate 110 may be bonded to an upper surface of a first carrier substrate 104 for the front surface of the first semiconductor substrate 110 to face downward. The first carrier substrate 104 may support the first semiconductor substrate 110 and may include any of various materials that may be bonded with the first semiconductor substrate 110. For example, the first carrier substrate 104 may be a silicon substrate. Various methods may be used as a bonding method. For example, dielectric-to-dielectric bonding or hybrid bonding may be used. For another example, an adhesive layer may be positioned on the upper surface of the first carrier substrate 104, and the first semiconductor substrate 110 may be bonded to the first carrier substrate 104 by the adhesive layer. A variety of other methods may also be utilized.

In a state where the front surface of the first semiconductor substrate 110 is bonded to the first carrier substrate 104, a portion of the rear surface of the first semiconductor substrate 110 positioned thereon may be removed to perform a thinning process of reducing a thickness of the first semiconductor substrate 110. The thinning process may use, for example, a grinding process, a chemical mechanical polish (CMP) process, or the like.

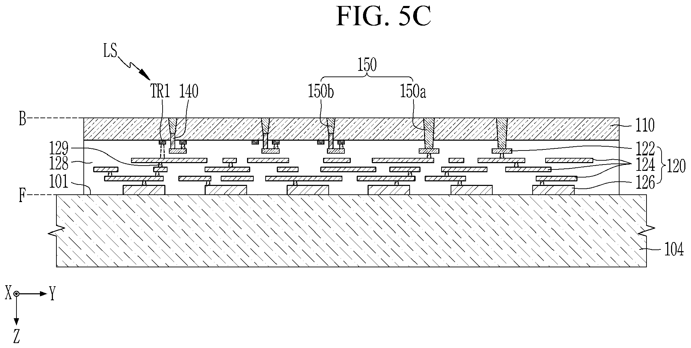

Next, as shown in FIG. 5C, a first through via 150 may be formed in the first semiconductor substrate 110. The first through via 150 in an embodiment may include a first signal through via 150a extending from the rear surface of the first semiconductor substrate 110 to the first front side layer 122 (e.g., pad part 122a in FIG. 2) and a first power through via 150b extending from the rear surface of the semiconductor substrate 110 to the back side of the buried wiring 140. The first through via 150 may be formed by forming a via through, for example, a laser process, an etching process, or the like, and filling the via with a conductive material. However, embodiments are not limited thereto, and the first through via 150 may be formed in any of various ways.

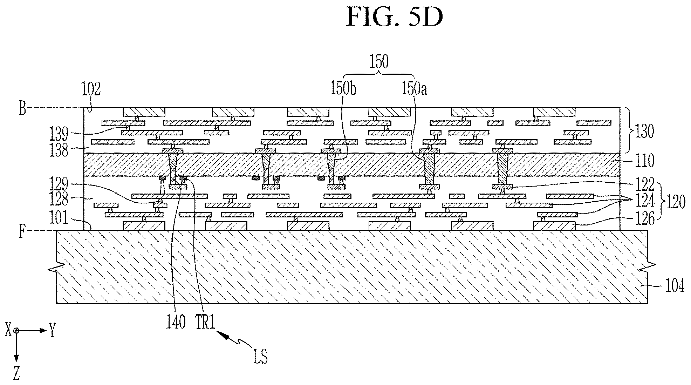

Next, as shown in FIG. 5D, a back side wiring layer 130 may be formed on the rear surface of the first semiconductor substrate 110. Here, a back side wiring layer 130 having a desired path may be formed by insulating or connecting a plurality of wiring layers 132 and 134 and a first rear surface pad 136 from each other or with each other by using an interlayer insulating layer 138 and a contact plug 139. Some of the wiring layers 132 may also be referred to as first back side layers, and some of the wiring layers 134 may also be referred to as second back side layers. The back side wiring layer 130 may be formed through any of various manufacturing processes, and embodiments are not limited thereto.

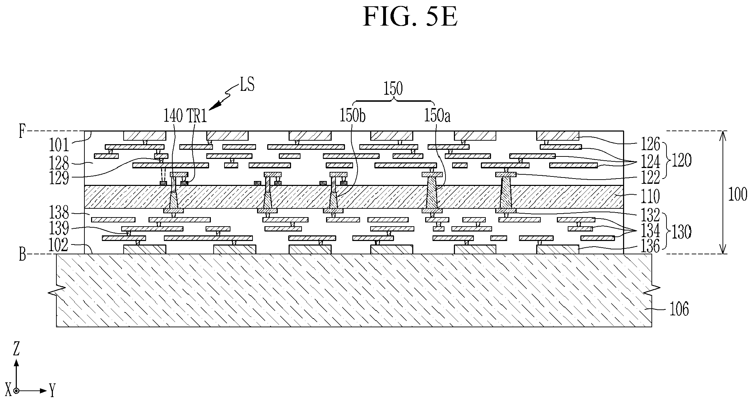

Next, as shown in FIG. 5E, a second carrier substrate 106 may be bonded to the rear surface of the first semiconductor substrate 110, and a transfer bonding process may be performed to remove or separate the first carrier substrate 104 positioned on the front surface of the first semiconductor substrate 110.

The transfer bonding process may be performed by any of various processes. For example, the first carrier substrate 104 may be removed by the grinding process, the chemical mechanical polish process or the like, or may be separated into a separate substrate by a lift-off process or an adhesive layer removal process. When the first carrier substrate 104 is separated into the separate substrate, the first carrier substrate 104 may be reused.

Accordingly, a first chip 100 may be formed while being laminated on the second carrier substrate 106.

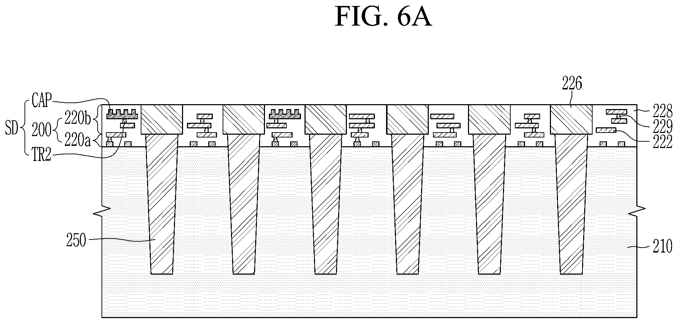

Next, the forming of the laminated structure (S20) is described in detail with reference to FIGS. 6A to 6D. FIGS. 6A to 6D are process diagrams showing the forming of the laminated structure (S20) in the method of manufacturing a semiconductor package 10 according to an embodiment. Here, the laminated structure may be a structure in which the first chip 100 and the second chip 200 are laminated.

As shown in FIG. 6A, a second through via 250 and a second semiconductor element unit SD may be formed on the front surface of a second semiconductor substrate 210. For example, a first wiring unit 220a and the second through via 250 may be formed on the front surface of the second semiconductor substrate 210, and a second wiring unit 220b including a first pad 226 connected to the second through via 250 may then be formed above the first wiring unit 220a and the second through via 250. Here, the first wiring unit 220a may be a front end of line (FEOL), and the second wiring unit 220b may be a back end of line (BEOL).

The second through via 250 may be formed by forming a via through, for example, a laser process, an etching process, or the like, and then filling the via with a conductive material. However, embodiments are not limited thereto, and the second through via 250 may be formed in any of various ways. The second semiconductor element unit SD may be formed through any of various manufacturing processes.

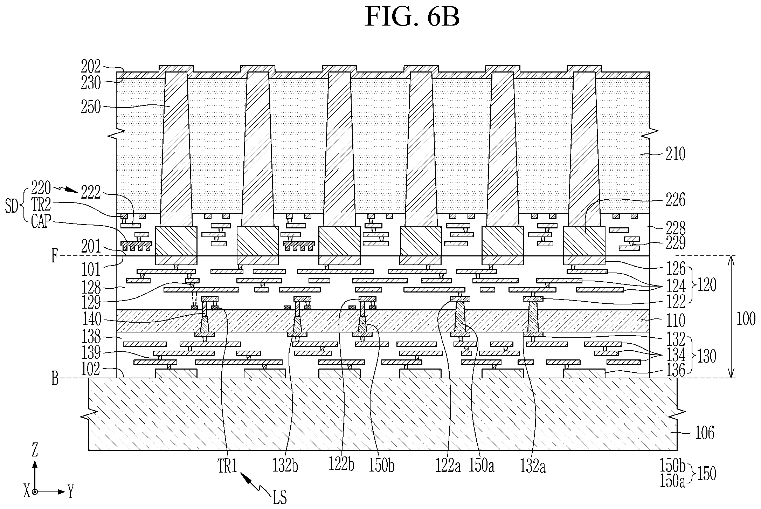

Next, as shown in FIG. 6B, a first surface (e.g., first surface 201 of the second chip 200) of the second semiconductor substrate 210 where the second semiconductor element unit SD is formed may be bonded to a front surface 101 of the first chip 100. For example, the first chip 100 and the second semiconductor substrate 210 (or the second chip 200 including the second semiconductor substrate 210) may be bonded with each other by hybrid bonding.

In addition, in a state where the first surface of the second semiconductor substrate 210 is bonded to the front surface 101 of the first chip 100, a portion of a second surface side of the second semiconductor substrate 210 positioned thereon may be removed to perform a thinning process of exposing the second through via 250 to the second surface of the semiconductor substrate 210. The thinning process may use, for example, the grinding process, the chemical mechanical polish (CMP) process, or the like. In addition, an etch back process may be performed on the second surface of the second semiconductor substrate 210 for a portion of the second through via 250 to be exposed to the second surface of the second semiconductor substrate 210. In addition, an insulating layer 230 may be formed while covering the second surface 202 and the second through via 250 of the second chip 200. Various processes may be applied as the etch-back process and a process of forming the insulating layer 230.

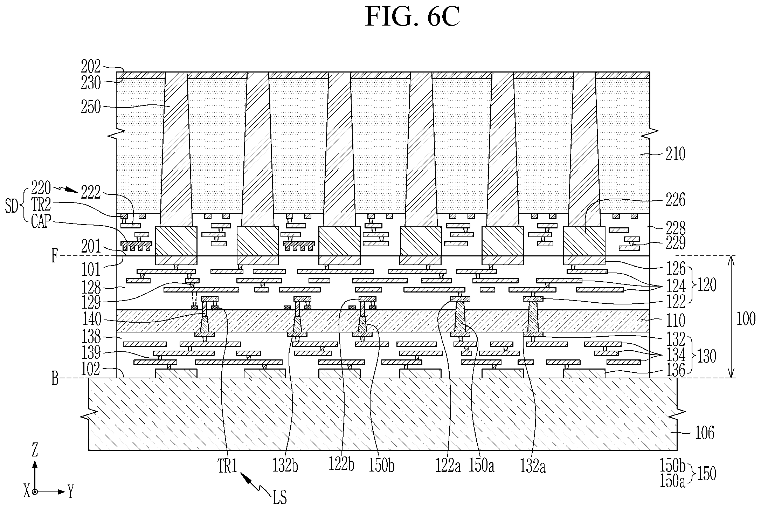

Next, as shown in FIG. 6C, the insulating layer 230 formed on the second through via 250 may be removed for the second through via 250 to be exposed to the second surface of the second semiconductor substrate 210. Accordingly, its portion other than the second through via 250 may be entirely covered by the insulating layer 230. The insulating layer 230 formed on the second through via 250 may be removed by any of various processes, for example, the chemical mechanical polish process.

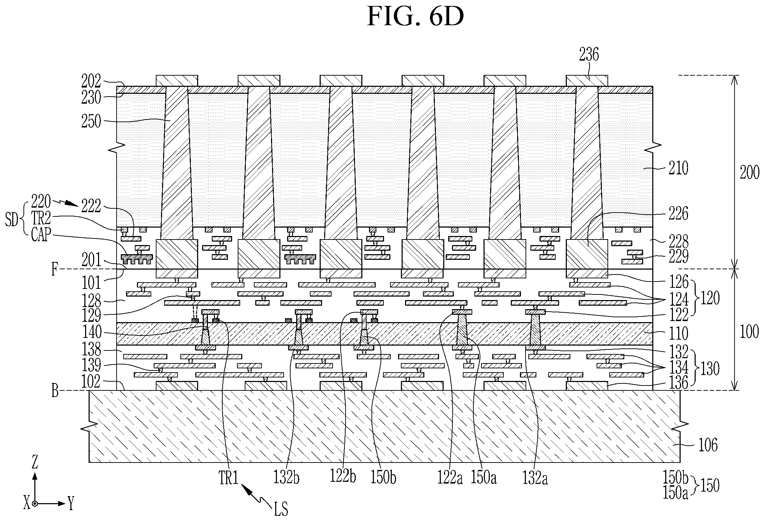

Next, as shown in FIG. 6D, a second pad 236 electrically connected to the second through via 250 may be formed. The second pad 236 may be formed by any of various processes using a conductive material. It is thus possible to complete the manufacture of the laminated structure in which the second chip 200 is laminated on the first chip 100.

An embodiment as described above illustrates that the second through via 250 has a middle through silicon via structure. That is, the first wiring unit 220a may be formed, the second through via 250 may then be formed in the front surface of the second semiconductor substrate 210, and the second wiring unit 220b may be formed thereabove. In this way, the second semiconductor substrate 210 having the second through via 250 may be attached to the first chip 100.

However, embodiments are not limited thereto. For example, in an embodiment, the second through via 250 may have a last through silicon via structure. That is, the first and second wiring units 220a and 220b may be formed on the first surface side of the second semiconductor substrate 210, the first surface of the second semiconductor substrate 210 may be bonded to the first chip 100 while facing the first chip 100, and the second through via 250 may then be formed in the second surface of the second semiconductor substrate 210. In this way, the second through via 250 may be formed after the second semiconductor substrate 210 is attached to the first chip 100. In addition, a process of forming the laminated structure in which the second chip 200 is laminated on the first chip 100 may be modified in various ways, and embodiments are not limited thereto.

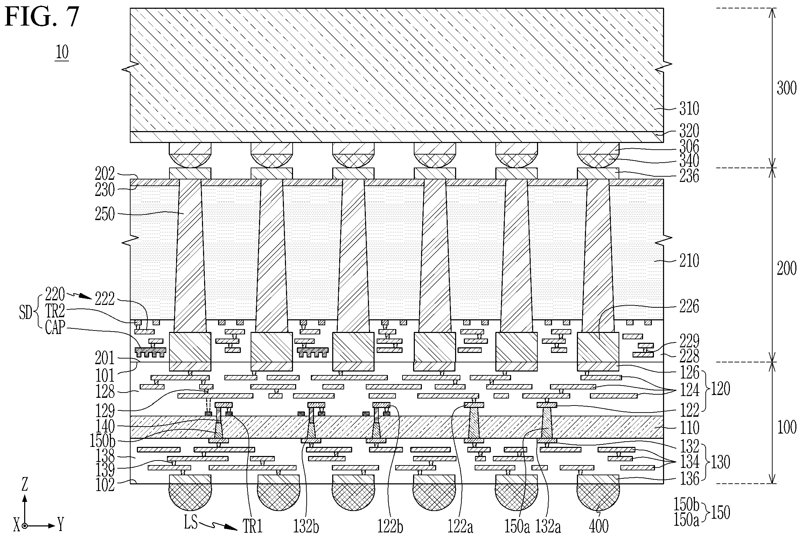

Next, the bonding of the third chip (S30) is described in detail with reference to FIG. 7. FIG. 7 is a process diagram showing the bonding of the third chip (S30) in the method of manufacturing a semiconductor package 10 according to an embodiment.

As shown in FIG. 7, in the bonding of the third chip (S30), a third chip 300 may be bonded to the laminated structure in which the second chip 200 is laminated on the first chip 100. In this embodiment, a bump 340 positioned on a third pad 306 of the third chip 300 may be aligned on the second pad 236 of the second chip 200 to bond the two chips with each other. The second pad 236 and the third pad 306 may then be electrically connected with each other by the bump 340, and the second chip 200 and the third chip 300 may be bonded with each other. The semiconductor package 10 may then be formed by removing the second carrier substrate 106 and forming a connection bump 400.

According to an embodiment, the first chip 100 and the second chip 200 may be bonded with each other by hybrid bonding in which the first front surface pad 126 and the first pad 226 are bonded (for example, directly bonded) with each other to form the laminated structure, thereby increasing connection density and effectively reducing a transfer path. This configuration is presented in consideration of the first chip 100 having a fine wiring structure or fine pattern. In addition, the manufacturing process may be simplified by bonding the second chip 200 having a larger wiring structure or pattern with the third chip 300 by using the bump 340 of the third chip 300. That is, in an embodiment, performance of the semiconductor package 10 may be increased by using a bonding method considering structures of the first chip 100, the second chip 200 and/or the third chip 300.

Hereinafter, a semiconductor package according to an embodiment is described in detail. For convenience of explanation, a further description of components and technical aspects previously described may be omitted. In addition, combinations of the above embodiments or modified examples thereof and the following embodiments or modified examples thereof also fall within the scope of the present disclosure.

FIG. 8 is a partial cross-sectional view schematically showing a semiconductor package 10a according to an embodiment.

Referring to FIG. 8, in a first chip 100 of the semiconductor package 10a according to an embodiment, a buried wiring 140 may extend from a connection part 122b of a first front side layer 122 to a back side wiring layer 130 (e.g., first pad part 132a of a first back side layer 132) to connect (e.g., directly connect) the connection part 122b with the back side wiring layer 130. Accordingly, a first power through via (e.g., 150b in FIG. 2) may be omitted according to embodiments. That is, according to embodiments, the first power through via 150b aligned with the buried wiring 140 is not formed, thus simplifying a manufacturing process.

FIG. 9 is a partial cross-sectional view schematically showing a semiconductor package 10b according to an embodiment.

Referring to FIG. 9, in a first chip 100 of the semiconductor package 10b according to an embodiment, a buried wiring 140 may extend from the back side of a first transistor TR1 to a back side wiring layer 130 to be directly connected thereto. Accordingly, in an embodiment, a first front side layer 122 does not include a connection part (e.g., 122b in FIG. 2). In this way, a power transfer path may be reduced according to embodiments.

FIG. 10 is a partial cross-sectional view schematically showing a semiconductor package 10c according to an embodiment.

Referring to FIG. 10, in the semiconductor package 10c according to an embodiment, a second chip 200 and a third chip 300 may be bonded with each other by hybrid bonding without a bump (e.g., 340 in FIG. 2). That is, a second pad 236a of the second chip 200 and a bonding pad 306a of the third chip 300 may be bonded (for example, directly bonded) with each other. In this way, connection density between the second chip 200 and the third chip 300 may be increased, which may effectively reduce the transfer path.

For example, the second pad 236a of the second chip 200 and the bonding pad 306a of the third chip 300 may include copper and be formed by a damascene process. Insulating layers 230 and 330 covering portions of the second chip 200 and the third chip 300 where the second pad 236a and the bonding pad 306a are not formed may include any of various insulating materials. The second pad 236a of the second chip 200 and the bonding pad 306a of the third chip 300 may then be bonded with each other to have a copper-to-copper structure. The insulating layers 230 and 330 may be formed by any of various processes. However, embodiments are not limited thereto, and a process of forming the second pad 236a, the bonding pad 306a, or the like may be modified in various ways.

For example, the semiconductor package 10c according to an embodiment may be formed by bonding the second chip 200 with the third chip 300 by using hybrid bonding in the bonding of the third chip (S30) in FIG. 4.

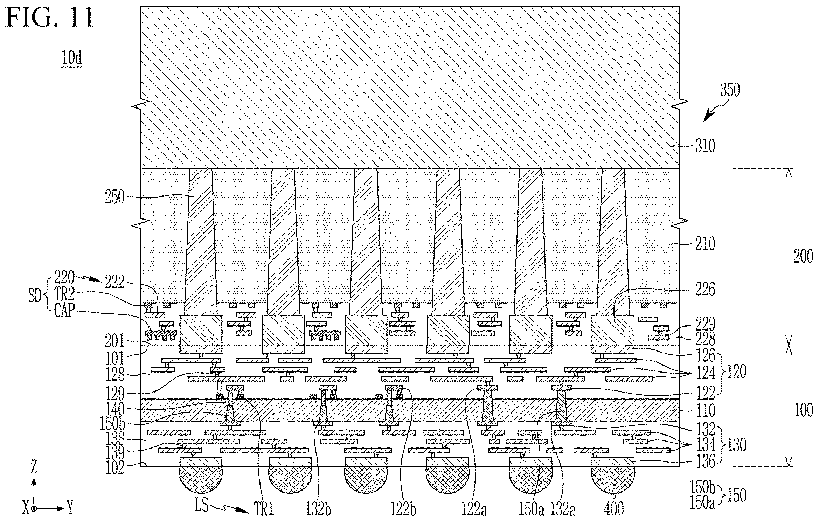

FIG. 11 is a partial cross-sectional view schematically showing a semiconductor package 10d according to an embodiment.

Referring to FIG. 11, the semiconductor package 10d according to an embodiment does not include a third chip (e.g., 300 in FIG. 2), and a heat dissipation member 350 may be bonded onto a second chip 200. The heat dissipation member 350 may serve to dissipate heat generated in the semiconductor package 10d (e.g., a first semiconductor element unit LS, a second semiconductor element unit SD, or the like), and also serve to firmly maintain the semiconductor package 10d.

The heat dissipation member 350 may include any of various materials capable of dissipating heat. For example, the heat dissipation member 350 may include a third semiconductor substrate 310 having a thickness equal to or greater than that of a second semiconductor substrate 210. However, embodiments are not limited thereto, and the material, thickness or the like of the heat dissipation member 350 may be variously modified. For example, the thickness of the third semiconductor substrate 310 may be larger than that of a first semiconductor substrate 110 and smaller than that of the second semiconductor substrate 210.

Here, another wiring layer may be positioned on the rear surface of the second chip 200, and a second through via 250 may electrically connect a second semiconductor element unit SD positioned on a first surface 201 of the second chip 200 with another wiring layer positioned on a second surface 202 of the second chip 200. However, embodiments are not limited thereto, and the electrical connection structure by the second through via 250 may be modified in various ways. In addition, FIG. 11 shows that the second chip 200 includes none of second pads 236 and 236a and an insulating layer 230. However, embodiments are not limited thereto, and a pad may be provided, or electrical connection may be made, through bumps or wires according to embodiments.

In this way, the semiconductor package 10d may be formed only with a laminated structure of the first chip 100 and the second chip 200. In this case, heat dissipation efficiency may be increased by laminating the heat dissipation member 350 on the second chip 200.

For example, the semiconductor package 10d according to an embodiment may be formed by bonding the heat dissipation member 350 on the second chip 200 instead of the bonding of the third chip (S30) in FIG. 4. The heat dissipation member 350 may be bonded by any of various bonding processes. For example, a bonding process using an adhesive layer or dielectric-to-dielectric bonding (hybrid bonding) may be used.

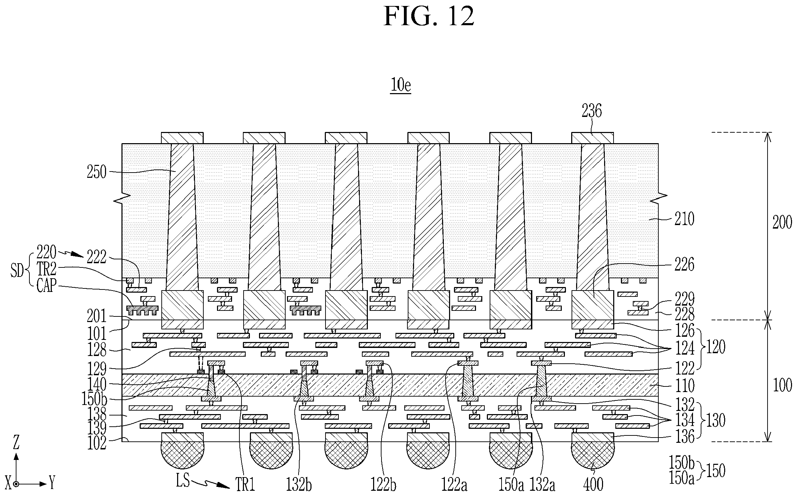

FIG. 12 is a partial cross-sectional view schematically showing a semiconductor package 10e according to an embodiment.

Referring to FIG. 12, the semiconductor package 10e according to an embodiment may have a laminated structure including a first chip 100 and a second chip 200. That is, in an embodiment, the semiconductor package 10e does not include a third chip 300 by design. Accordingly, the semiconductor package 10e having a short transfer path may be formed by using this structure.

For example, as shown in FIG. 12, a second pad 236 may be positioned on the second chip 200 to be connected to an external circuit. For example, a wire may be connected to the second pad 236 and connected to the external circuit through the wire connection. For another example, another wiring layer or the like may be positioned on the rear surface of the second chip 200, and a second through via 250 may electrically connect a second semiconductor element unit SD positioned on the front surface with another wiring layer positioned on the rear surface. In this case, a second pad 236 of the second chip 200 is not provided. However, embodiments are not limited thereto, and the electrical connection structure by the second through via 250 may have a different structure.

For example, the semiconductor package 10e according to an embodiment may be formed by additionally performing a process of forming the laminated structure in FIG. 4 (e.g., process of forming the second pad 236 in S20) without performing the bonding of the third chip (S30) in FIG. 4.

As is traditional in the field of the present disclosure, embodiments are described, and illustrated in the drawings, in terms of functional blocks, units and/or modules. Those skilled in the art will appreciate that these blocks, units and/or modules are physically implemented by electronic (or optical) circuits such as logic circuits, discrete components, microprocessors, hard-wired circuits, memory elements, wiring connections, etc., which may be formed using semiconductor-based fabrication techniques or other manufacturing technologies. In the case of the blocks, units and/or modules being implemented by microprocessors or similar, they may be programmed using software (e.g., microcode) to perform various functions discussed herein and may optionally be driven by firmware and/or software. Alternatively, each block, unit and/or module may be implemented by dedicated hardware, or as a combination of dedicated hardware to perform some functions and a processor (e.g., one or more programmed microprocessors and associated circuitry) to perform other functions.

While the present disclosure has been particularly shown and described with reference to embodiments thereof, it will be understood by those of ordinary skill in the art that various changes in form and detail may be made therein without departing from the scope of the present disclosure as defined by the following claims.

## Claims

1. A semiconductor package, comprising:
a first chip comprising a first semiconductor substrate comprising a first through via, a semiconductor element positioned on a front surface of the first semiconductor substrate, and a back side wiring layer comprising a back side power wiring positioned on a rear surface of the first semiconductor substrate and electrically connected to the semiconductor element; and
a second chip bonded to and electrically connected to a front surface of the first chip, and comprising a second through via having a size greater than a size of the first through via.

2. The semiconductor package of claim 1, wherein
the first chip has a finer wiring structure or finer pattern than the second chip.

3. The semiconductor package of claim 2, wherein
the first chip has a first contact gate or wiring pitch equal to about 10 nm or less, and
the second chip has a second contact gate or wiring pitch greater than the first contact gate or wiring pitch and equal to about 3 nm to about 50 nm.

4. The semiconductor package of any preceding claim, wherein
the second chip further comprises a second semiconductor substrate, and
a thickness of the second semiconductor substrate is greater than a thickness of the first semiconductor substrate.

5. The semiconductor package of claim 4, wherein
the thickness of the first semiconductor substrate is equal to about 150 nm to about 700 nm, and
the thickness of the second semiconductor substrate is equal to about 50 µm or less.

6. The semiconductor package of any preceding claim, wherein
a diameter of the first through via is equal to about 1 µm or less, and
a diameter of the second through via is equal to about 1 µm or more.

7. The semiconductor package of any preceding claim, wherein
the first chip is a logic unit, and
the second chip is a memory unit.

8. The semiconductor package of any preceding claim, wherein
the first through via comprises a first signal through via that transfers an input/output signal and a first power through via that transfers power, and
a size of the first signal through via is greater than a size of the first power through via.

9. The semiconductor package of claim 8, wherein
a diameter of the first power through via is equal to about 100 nm or less, and
a diameter of the first signal through via is equal to about 100 nm to about 1 µm.

10. The semiconductor package of any preceding claim, wherein
the first chip further comprises a buried wiring electrically connecting a first transistor of the semiconductor element with the back side power wiring.

11. The semiconductor package of claim 10, wherein
the buried wiring extends from a back side of the first transistor to the back side power wiring.

12. The semiconductor package of any preceding claim, wherein
the first chip and the second chip are bonded with each other by hybrid bonding.

13. The semiconductor package of claim 12, wherein
the second chip further comprises a transistor positioned on a surface of the second chip that is bonded to the first chip, and
the first chip and the second chip have a face-to-face structure by being bonded with each other.

14. The semiconductor package of any preceding claim, further comprising:
a third chip bonded to a second surface of the second chip that is opposite to a first surface of the second chip bonded to the first chip, a third semiconductor substrate, or a heat dissipation member.

15. A method of manufacturing a semiconductor package, the method comprising:
forming a first chip comprising a first semiconductor substrate comprising a first through via, a semiconductor element positioned on a front surface of the first semiconductor substrate, and a back side wiring layer comprising a back side power wiring positioned on a rear surface of the first semiconductor substrate and electrically connected to the semiconductor element; and
forming a laminated structure in which a second chip comprising a second through via having a size greater than a size of the first through via is bonded to a front surface of the first chip.

## Amended claims

### Amended claims in accordance with Rule 137(2) EPC.

1. A semiconductor package (10), comprising:
a first chip (100) comprising a first semiconductor substrate (110) comprising a first through via (150), a semiconductor element positioned on a front surface of the first semiconductor substrate (110), and a back side wiring layer (130) comprising a back side power wiring positioned on a rear surface of the first semiconductor substrate (110) and electrically connected to the semiconductor element; and
a second chip (200) bonded to and electrically connected to a front surface of the first chip (100), and comprising a second through via (250) having a diameter greater than a diameter of the first through via (150).

2. The semiconductor package (10) of claim 1, wherein
the first chip (100) has a finer wiring structure or finer pattern than the second chip (200).

3. The semiconductor package (10) of claim 2, wherein
the first chip (100) has a first contact gate or wiring pitch equal to about 10 nm or less, and
the second chip (200) has a second contact gate or wiring pitch greater than the first contact gate or wiring pitch and equal to about 3 nm to about 50 nm.

4. The semiconductor package (10) of any preceding claim, wherein
the second chip (200) further comprises a second semiconductor substrate (210), and
a thickness of the second semiconductor substrate (210) is greater than a thickness of the first semiconductor substrate (110).

5. The semiconductor package (10) of claim 4, wherein
the thickness of the first semiconductor substrate (110) is equal to about 150 nm to about 700 nm, and
the thickness of the second semiconductor substrate (210) is equal to about 50 µm or less.

6. The semiconductor package (10) of any preceding claim, wherein
a diameter of the first through via (150) is equal to about 1 µm or less, and
a diameter of the second through (250) via is equal to about 1 µm or more.

7. The semiconductor package (10) of any preceding claim, wherein
the first chip (100) is a logic unit, and
the second chip (200) is a memory unit.

8. The semiconductor package (10) of any preceding claim, wherein
the first through via (150) comprises a first signal through via (150a) that transfers an input/output signal and a first power through via (150b) that transfers power, and
a size of the first signal through via (150a) is greater than a size of the first power through via (150b).

9. The semiconductor package (10) of claim 8, wherein
a diameter of the first power through via (150b) is equal to about 100 nm or less, and
a diameter of the first signal through via (150a) is equal to about 100 nm to about 1 µm.

10. The semiconductor package (10) of any preceding claim, wherein
the first chip (100) further comprises a buried wiring electrically connecting a first transistor (TR1) of the semiconductor element with the back side power wiring.

11. The semiconductor package (10) of claim 10, wherein
the buried wiring extends from a back side of the first transistor (TR1) to the back side power wiring.

12. The semiconductor package (10) of any preceding claim, wherein
the first chip (100) and the second chip (200) are bonded with each other by hybrid bonding.

13. The semiconductor package (10) of claim 12, wherein
the second chip (200) further comprises a transistor positioned on a surface of the second chip (200) that is bonded to the first chip (100), and
the first chip (100) and the second chip (200) have a face-to-face structure by being bonded with each other.

14. The semiconductor package (10) of any preceding claim, further comprising:
a third chip (300) bonded to a second surface of the second chip (200) that is opposite to a first surface of the second chip (200) bonded to the first chip (100), a third semiconductor substrate (310), or a heat dissipation member (350).

15. A method of manufacturing a semiconductor package (10), the method comprising:
forming a first chip (100) comprising a first semiconductor substrate (110) comprising a first through via (150), a semiconductor element positioned on a front surface of the first semiconductor substrate (110), and a back side wiring layer comprising a back side power wiring positioned on a rear surface of the first semiconductor substrate (110) and electrically connected to the semiconductor element; and
forming a laminated structure in which a second chip (200) comprising a second through via (250) having a diameter greater than a diameter of the first through via (150) is bonded to a front surface of the first chip (100).
